(19) Europäisches Patentamt
European Patent Office
Office européen des brevets

(11) **EP 2 843 671 A1**

(12) **EUROPEAN PATENT APPLICATION**
published in accordance with Art. 153(4) EPC

(43) Date of publication:
04.03.2015 Bulletin 2015/10

(51) Int Cl.:
*H01B 12/04* (2006.01)  *C01B 35/04* (2006.01)
*C01G 1/00* (2006.01)  *H01B 12/08* (2006.01)
*H01B 13/00* (2006.01)  *H01F 6/06* (2006.01)

(21) Application number: 13782254.0

(22) Date of filing: 25.04.2013

(86) International application number:
PCT/JP2013/062185

(87) International publication number:
WO 2013/161930 (31.10.2013 Gazette 2013/44)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 26.04.2012  JP 2012101572

(71) Applicants:
• The University of Tokyo
  Bunkyo-ku,
  Tokyo 113-8654 (JP)
• Hitachi, Ltd.
  Tokyo 100-8280 (JP)

(72) Inventors:
• KODAMA Motomune
  Tokyo 100-8280 (JP)
• TANAKA Kazuhide
  Tokyo 100-8280 (JP)
• SHIMOYAMA Junichi
  Tokyo 113-8654 (JP)
• YAMAMOTO Akiyasu
  Tokyo 113-8654 (JP)

(74) Representative: Beetz & Partner mbB
Patentanwälte
Steinsdorfstraße 10
80538 München (DE)

(54) **SUPERCONDUCTING WIRE, SUPERCONDUCTING WIRE PRECURSOR BODY AND FABRICATION METHOD THEREOF, AND SUPERCONDUCTING MULTI-CORE CONDUCTOR PRECURSOR BODY**

(57) Provided are a superconducting wire, etc. having a wire length which is sufficiently longer than that of the conventional one, and a critical current density which is uniformly high over the entire length thereof. A density of the magnesium diboride core (1) is 1.5g/cm$^3$ or higher. In a void (4) which is present in an arbitrary longitudinal cross-section in the longitudinal direction of the superconducting wire (10), when a length of a line segment which connects the most distant two points in a closed curve forming the void (4) is assumed to be L, among the voids (4) with length L of 20 $\mu$m or greater, the number of voids (4) with an angle formed by the line segment and the axis in the longitudinal direction of the superconducting wire (10) of 45° or greater is less than the number of voids (4) with the angle formed by the line segment and the axis in the longitudinal direction of the superconducting wire (10) of smaller than 45°. In an arbitrary 100$\mu$m region of the longitudinal direction of the longitudinal cross-section, when a virtual straight line approximated by the least squares method is drawn for a boundary curve between the magnesium diboride core (1) and the metal sheath (2), the distance between the approximate straight line and the boundary curve is 10 $\mu$m or less.

EP 2 843 671 A1

FIG.2A

FIG.2B

L

4

LINE SEGMENT

θ

AXIS IN LONGITUDINAL
DIRECTION OF WIRE

**Description**

{Technical Field}

The present invention relates to a superconducting wire, a superconducting wire precursor body and a fabrication method thereof, and a superconducting multi-core conductor precursor body.

{Background Art}

Magnesium diboride ($MgB_2$) is a superconductor discovered in 2001. It has the highest critical temperature (39K) among superconductors using metal. Therefore, by using magnesium diboride, it is possible to operate a superconducting equipment, which has been operated by cooling to liquid helium temperature (4.2K), at higher temperature (10K to 20K) without using liquid helium. In particular, it is expected that magnesium diboride is applied to equipments such as a nuclear magnetic resonance spectrometer (an NMR equipment), a medical MRI equipment (medical magnetic resonance imaging equipment), which use a magnetic field having a very small temporal variation. This is because a problem of magnetic flux creep, which is significant in a superconductor etc. using copper oxide, is reduced in a superconductor using magnesium diboride.

A linearized superconductor (superconducting wire) is, for example, obtained by fabricating a wire by performing an area reduction process and firing the wire after filling a raw material powder into a metal sheath. The superconducting wire obtained in this manner has a critical current density suitable for a practical use. This fabrication method is referred to as a powder-in-tube method.

The powder-in-tube method is roughly divided into two methods in accordance with the raw material powder to be filled. That is, a method for producing magnesium diboride by using boron powder and magnesium powder as the raw material powder and firing in the metal sheath is referred to as an in-Situ method. Further, a method of using magnesium diboride as the raw material powder and strongly binding together the magnesium diboride in the metal sheath is referred to as an ex-Situ method.

In connection with such techniques, Patent Documents 1 and 2 are known.

{Citation List}

{Patent Literature}

{Patent Document 1}
Japanese Patent No. 4667638
{Patent Document 2}
Japanese Patent Application Publication No. 2003-031057

{Summary of Invention}

{Technical Problem}

In a superconducting magnet using a superconducting wire containing magnesium diboride, in order to generate a predetermined magnetic field, it is important to increase the product of the critical current density and wire length of the superconducting wire. As a value of the product is larger, a range of the magnetic field which can be generated is larger. Therefore, it is required for the superconducting wire that the wire length is long enough and the critical current density is uniformly high over the entire length thereof.

The present invention has been made in view of the above problems, an object of the present invention is to provide a superconducting wire having a wire length which is sufficiently longer than that of the conventional one, and a critical current density which is uniformly high over the entire length thereof, a precursor of the superconducting wire and a fabrication method thereof, and a precursor of the superconducting multi-core conductor.

{Solution to Problem}

As a result of intensive studies in order to solve the above problems, the present inventors have found that it is possible to solve the above problems by satisfying a predetermined condition for magnesium diboride contained in the superconducting wire, and have completed the present invention.

{Advantageous Effects of Invention}

According to the present invention, it is possible to provide a superconducting wire having a wire length which is sufficiently longer than that of the conventional one, and a critical current density which is uniformly high over the entire length thereof, a precursor of the superconducting wire and a fabrication method thereof, and a precursor of the superconducting multi-core conductor.

{Brief Description of Drawings}

FIG. 1 is a perspective view of a superconducting wire 10;
FIG. 2A is a cross-sectional view of the superconducting wire 10;
FIG. 2B is a diagram for describing the number of voids in FIG. 2A;
FIG. 3 is a cross-sectional view of a conventional superconducting wire 11;
FIG. 4 is a diagram describing a boundary between a magnesium diboride core 1 and a metal sheath 2;
FIG. 5 is a diagram describing the boundary between the magnesium diboride core 1 and the metal sheath 2;
FIG. 6 is a graph for showing relationships between a critical current density and an applied magnetic field;
FIG. 7 is a graph for showing the relationships between the critical current density and the applied magnetic field;
FIG. 8 is a graph for showing relationships between the critical current density and a mixing ratio of magnesium diboride;
FIG. 9 is a graph for showing relationships between a density and the mixing ratio of magnesium diboride; and
FIG. 10 is a graph for showing relationships between the critical current density and the applied magnetic field.

{Description of Embodiments}

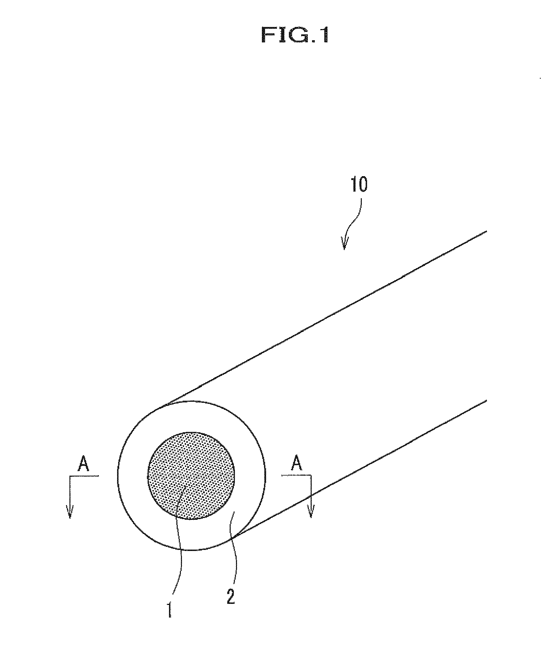

Hereinafter, an embodiment to implement the present invention (the present embodiment) will be described with reference to drawings as appropriate. For convenience of illustration, a reduction ratio or an enlargement factor in each drawing is not constant, and the same member is not necessarily shown in the same size in all drawings. Further, for convenience of description, in particular, some members may be shown enlarged or reduced in the same drawing.
[1. Superconducting wire]
As shown in FIG. 1, a superconducting wire 10 of the present embodiment has a magnesium diboride core 1 made of magnesium diboride which is electrically continuous, and a metal sheath 2 which covers the magnesium diboride core 1. The superconducting wire 10 satisfies the following three physical properties.
Physical property 1: The density of the magnesium diboride core 1 is 1.5g/cm$^3$ or higher.
Physical property 2: In a void which is present in an arbitrary longitudinal cross-section in the longitudinal direction of the superconducting wire 10, when a length of a line segment which connects the most distant two points in a closed curve forming the void is assumed to be L, among the voids with length L of 20 $\mu$m or more, the number of voids having angles of 45° or more, which is formed by the line segment and the axis in the longitudinal direction of the superconducting wire 10, is less than the number of voids having angles smaller than 45°, which is formed by the line segment and the axis in the longitudinal direction of the superconducting wire 10.
Physical property 3: In an arbitrary 100$\mu$m region in the longitudinal direction of the longitudinal cross-section, when a virtual straight line approximated by the least squares method is drawn for a boundary curve between the magnesium diboride core 1 and the metal sheath 2, the distance between the approximate straight line and the boundary curve is 10 $\mu$m or less.

In the following, each of the physical properties will be described.

<Physical property 1>

The density of the magnesium diboride core 1 contained in the superconducting wire 10 is 1.5g/cm$^3$ or higher. However, the density of the magnesium diboride core 1 is preferably 1.57g/cm$^3$ or higher, and an upper limit thereof is preferably 2.36g/cm$^3$ or lower, because of the facts that a true density of magnesium diboride is 2.62g/cm$^3$ and that when a packing density of powder exceeds 90%, liquidity of the powder is deteriorated to be linearized and wire fabrication becomes difficult. Note that, the density of the magnesium diboride core 1 can be measured for the magnesium diboride core 1 obtained by removing the metal sheath of the wire, by measuring a mass thereof by an electronic balance, calculating a volume from a size thereof by an electron microscope, and dividing the mass by the volume.

By allowing the density of the magnesium diboride core 1 to be in this range, it is possible to reduce the voids in the magnesium diboride core 1. Thus, in the superconducting wire 10 (magnesium diboride core 1), it is possible to increase paths in which superconducting current flows, thereby obtaining the superconducting wire 10 having an excellent critical current density.

<Physical property 2>

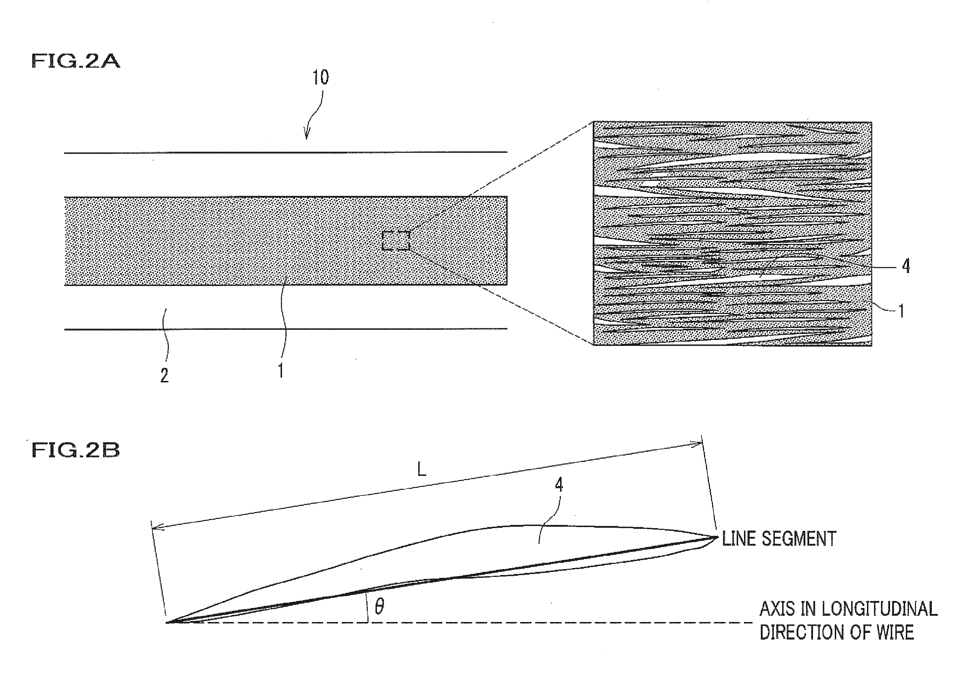

As shown in FIG. 2A as an arbitrary longitudinal cross-section (A-A line cross-section shown in FIG. 1) in the longitudinal direction of the superconducting wire 10, voids 4 are present in the magnesium diboride core 1. Note that, in the case of the in-Situ method, even when a raw material powder (boron, magnesium) is filled in the metal sheath 2 to the filling ratio of 100%, the voids 4 are formed by firing the metal sheath 2 after filling the raw material powder thereinto. In other words, by firing fine particles of boron and magnesium constituting the raw material powder, since they shrink not a little when magnesium diboride is formed, such voids 4 are formed. Further, also in the case of the ex-Situ method, the voids 4 are present because it is substantially impossible to fill the powders into the metal sheath 2 to the filling ratio of 100%.

As shown in FIG. 2B, when a length of a line segment which connects the most distant two points in a closed curve forming the void 4 is assumed to be L, among the voids with length L of 20 $\mu$m or more, the number of voids having angles $\theta$ of 45° or more, which is formed by the line segment and the axis in the longitudinal direction of the superconducting wire 10, is less than the number of voids having angles $\theta$ smaller than 45°, which is formed by the line segment and the axis in the longitudinal direction of the superconducting wire 10.

Note that, in this specification, the size of the void 4 is denoted by the length L of the line segment. Further, such a longitudinal cross-section can be observed by a method described in an embodiment to be described below.

For example, in an example shown in FIG. 2B, the angle $\theta$ is about 20°. The number of the voids 4 having angles $\theta$ smaller than 45° (does not include 45°) is more than the number of the voids 4 having angles $\theta$ of 45° or more. By satisfying such a condition, it is possible to increase the paths, in which superconducting current can flow, in the superconducting wire 10 (magnesium diboride core 1). That is, a diameter of the magnesium diboride core 1 in the superconducting wire 10 is about 20 $\mu$m to 500 $\mu$m, and in case that the number of the voids 4, which have the lengths L more than 20 $\mu$m and the angles $\theta$ of 45° or more, is too large, a possibility that a flow path of current in the magnesium diboride core 1 is closed is increased. Therefore, it is preferred that the number of voids 4 having angles $\theta$ of 45° or more, which are present in the magnesium diboride core 1, is as small as possible. Note that, even in a case that the angle $\theta$ of the void 4 is large, when the size of the void 4 is small with respect to the magnesium diboride core 1, a possibility that a current path is closed is low. Therefore, in the present embodiment, as the size of the void 4 for judging a size of the angle $\theta$, the voids 4 having the length L of the line segment of 20 $\mu$m or more are used.

Further, it is preferred that the angle $\theta$ of the void 4 described above is as small as possible. Specifically, as a limit of the size of the angle $\theta$, the angle $\theta$ is preferably less than 20°, and more preferably less than 10°.

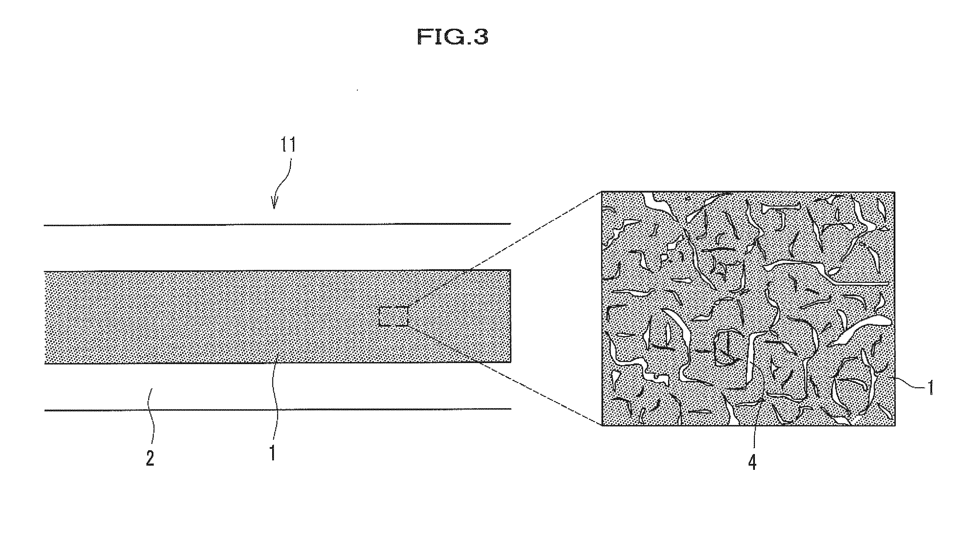

Although the details are described below in the embodiment, as an example which is not applicable to the superconducting wire 10 of the present embodiment, a superconducting wire 11 (conventional superconducting wire) is, for example, shown in FIG. 3. In the superconducting wire 11 shown in FIG. 3, there are many voids 4 in a direction perpendicular to a flow direction of the current (the angle $\theta$ is about 90°) in the magnesium diboride core 1. In this case, a possibility that a superconducting current path in the magnesium diboride core 1 is closed is increased, and there is a possibility that an excellent superconductive wire 10 having a uniform critical current density characteristics in the longitudinal direction cannot be obtained.

<Physical property 3>

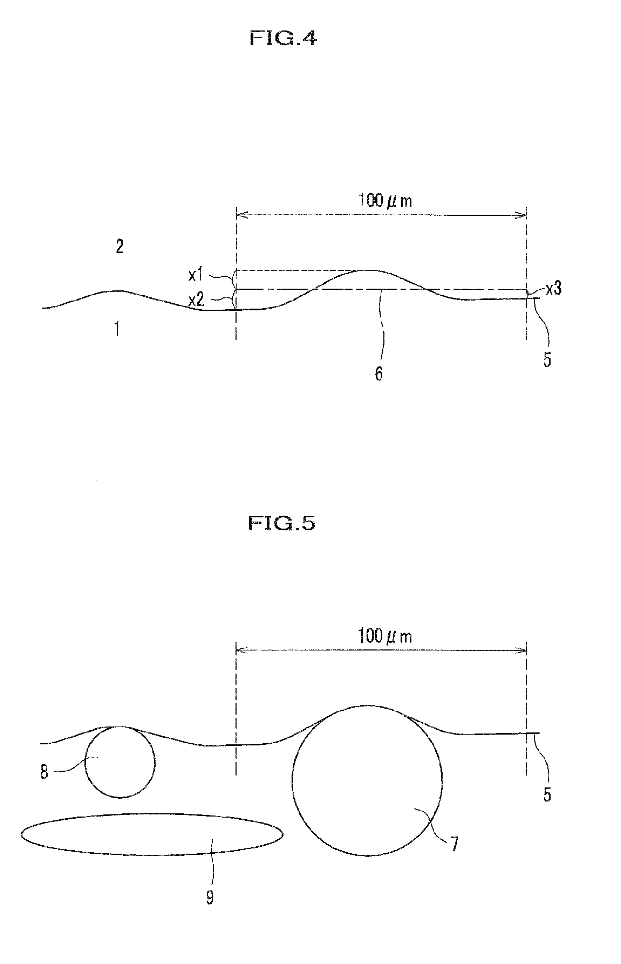

As shown in FIG. 4, in an arbitrary 100$\mu$m region in the longitudinal direction of the longitudinal cross-section of the superconducting wire 10, when a virtual straight line 6 approximated by the least squares method is drawn for a boundary curve 5 between the magnesium diboride core 1 and the metal sheath 2, all distances x1, x2, x3 between the approximate straight line 6 and the boundary curve 5 are 10 $\mu$m or less. In other words, the longest distance among the distances between the approximate straight line 6 and the boundary curve 5 is 10 $\mu$m or less. Incidentally, an illustrated undulation of a boundary surface 5 is caused by presence of boron 8 and magnesium diboride 7 with high hardness, as shown in FIG. 5.

This distance is ideally 0$\mu$m, that is, the boundary between the magnesium diboride core 1 and the metal sheath 2 is preferably in a completely flat state. However, since such a state is difficult in practice, the distance is normally 10 $\mu$m or less, but it is desired that the distance is preferably 5 $\mu$m or less, and more preferably 1 $\mu$m or less.

By allowing the distance between the approximate straight line 6 and the boundary curve 5 to be in this range, the boundary between the magnesium diboride core 1 and the metal sheath 2 is in a state close to the flat state. By allowing the boundary to be in the state close to the flat state, it is possible to obtain the excellent superconducting wire 10 having the uniform critical current density characteristics in the longitudinal direction.

Further, as described above, the hardness of magnesium diboride is, for example, higher than that of born, carbon, magnesium, and the like. Therefore, although details will be described below, in case that magnesium diboride is used as a part of raw material of the magnesium diboride core 1, when the raw material such as magnesium diboride is filled in the metal sheath 2 to be extended, the wire is sometimes cut off at a portion where magnesium diboride and the metal sheath 2 are in contact with each other. In other words, since the hardness of magnesium diboride is high, magnesium diboride excessively bites into the metal sheath 2 in some cases. As a result, the strength of the metal sheath 2 is reduced, and the wire is cut off. Therefore, to avoid such a phenomenon, a particle diameter of magnesium diboride is preferably 10 $\mu$m or less. In this manner, a distance L between the approximate straight line 6 and the boundary curve 5 can be 10 $\mu$m or less.

<Other physical properties>

In case that the superconductive wire 10 satisfies the three physical properties described above, other physical properties are arbitrary. For example, the magnesium diboride core 1 constituting the superconducting wire 10 contains magnesium diboride as described above. However, a part of boron atom sites of magnesium diboride contained may be substituted with carbon atom. By configuring the superconducting wire 10 in this manner, it is possible to cause lattice distortion in a crystal, thereby increasing the critical current density in a high magnetic field region of the superconducting wire 10.

Note that, such a substitution can be caused by firing a material (carbon source) containing carbon such as boron carbide in addition to boron and magnesium when preparing magnesium diboride. Further, an amount of the substitution can be controlled by appropriately changing a usage amount of the material containing carbon or the kind of the materials.

Further, the material of the metal sheath 2 constituting the superconducting wire 10 is not particularly limited. However, as the material of the metal sheath 2, it is preferable to use a metal material which does not react with magnesium, boron, magnesium diboride, and the like. Further, when a material other than these is used in the metal sheath 2, it is preferable to use a metal material which does not react with such a material. Further, by the same reason, the metal material having low reactivity with these materials or having a critical current density which does not significantly decrease even after reaction with these materials is also applicable to the metal sheath 2.

Such materials includes, for example, iron (Fe), niobium (Nb), tantalum (Ta), titanium (Ti), and the like. In particular, these are preferable as the material constituting the metal sheath 2. These may be used alone, or may be used in any ratio of two or more. Further, an alloy containing these as components may be used.

Further, an outer surface of the metal sheath 2 may be coated with a material containing copper (Cu). By coating the metal sheath 2 with such a material, workability of the superconducting wire 10 can be improved. Further, since copper has good conductivity and good thermal conductivity, by coating the metal sheath 2 with the material containing such a copper, it is possible to improve thermal instability inherent in the superconducting wire. Incidentally, as the material containing copper, either copper alone or a copper compound (copper alloy etc.) may be used. Further, as the material containing copper, a combination of copper alone and the copper compound may be used.

[2. Fabrication method of superconducting wire]

The superconducting wire 10 is obtained by firing a precursor of the superconducting wire 10. Hereinafter, a fabrication method of the superconducting wire 10 will be described, while describing firing conditions and physical properties of the precursor.

As the precursor, either a precursor A or a precursor B below is used. That is, the precursor A is a precursor, wherein the magnesium diboride core 1 constituting the superconducting wire 10 is formed by firing after filling magnesium and boron into the metal sheath 2, wherein the boron is crystalline, and wherein a volume average particle diameter of the boron is 2 $\mu$m or less.

Conventionally, so-called in-Situ method of firing after filling a mixture of magnesium and boron into the metal sheath has been used. However, according to this method, during reaction by firing magnesium and boron in the metal sheath, they shrink. As a result, since the packing density in the metal sheath is reduced (that is, many voids are present in some cases), the critical current density of the superconducting wire to be obtained has been low in some cases.

Further, conventionally, so-called ex-Situ method, in which after obtaining magnesium diboride by firing a mixture of magnesium and boron in advance, the obtained magnesium diboride is filled in the metal sheath, has also been used. However, according to this method, even in a case that magnesium diboride is filled in the metal sheath and extended, mutual electrical coupling of magnesium diboride has not been good in some cases. As a result, the critical current density of the superconducting wire has been low in some cases. Further, since the hardness of magnesium boride is high, when coarse magnesium diboride is present in the metal sheath, such magnesium diboride has excessively bitten into the metal sheath in some cases. As a result, the superconducting wire cannot be extended to a sufficient length during extending, and it has sometimes been cut off in the middle.

However, in the precursor A, crystalline boron with a volume average particle diameter of 2 μm or less is used as a part of the raw material. Therefore, also by the in-Situ method, it is possible to suppress volume shrinkage of the raw material powder in the metal sheath 2. This can make it possible to reduce an amount of voids which may be formed after firing. Therefore, there is no possibility that the critical current density of the superconducting wire 10 to be obtained becomes too low.

There is no particular limitation on an amount of magnesium and boron contained in the precursor A. However, based on the composition of magnesium diboride to be formed, it is preferred that 1 mol of magnesium per 2 mol of boron is filled in the metal sheath 2.

Further, as the precursor, the precursor B is a precursor, wherein the magnesium diboride core 1 constituting the superconducting wire 10 is formed by firing after filling magnesium, boron, and magnesium diboride into the metal sheath 2, and wherein a volume average particle diameter of magnesium diboride to be filled in the metal sheath 2 is 10 μm or less.

In the precursor B, as the raw material to form the magnesium diboride core 1, magnesium diboride with a volume average particle diameter of 10 μm or less is also used in addition to boron and magnesium. Magnesium diboride hardly shrinks any more even when fired. Therefore, it is possible to reduce the amount of voids which may be formed by performing the in-Situ method with magnesium and boron as the raw material. This can reduce the voids in the metal sheath 2, thereby increasing the packing density. As a result, an excellent critical current density of the superconducting wire 10 can be obtained.

However, in the present specification, "volume average particle diameter" is a value defined by the following equation (1). That is, it can be calculated from a particle size distribution measured by a particle size distribution measuring apparatus (for example, LA950 manufactured by HORIBA, Ltd.). The measurement principle is based on laser diffraction scattering method. A volume average particle diameter MV is an average value of particle diameters which are weighted by volumes. That is, if each volume of n pieces of particles is assumed to be $V_i$ (i = 1, 2, 3, ---, n) and each diameter of the particles is assumed to be $d_i$, the volume average particle diameter MV is calculated by the following equation (1).

$$MV = (d_1 \cdot V_1 + d_2 \cdot V_2 + \text{---} + d_n \cdot V_n) / (V_1 + V_2 + \text{---} + V_n) \qquad \text{--- (1)}$$

Magnesium diboride with a volume average particle diameter of 10 μm or less is obtained (prepared) by classification using a sieve after grinding solid magnesium diboride. It is sufficient to obtain a mixture by mixing magnesium, boron, and magnesium diboride which is prepared in this manner, and fill the mixture into the metal sheath 2.

There is no particular limitation on an amount of magnesium and boron contained in the precursor B. However, based on the composition of magnesium diboride to be formed, it is preferred that 1 mol of magnesium per 2 mol of boron is filled in the metal sheath 2. Further, an amount of magnesium diboride contained in the precursor B is not particularly limited. However, in the raw material powder to be filled in the metal sheath 2 constituting the precursor B, it is preferred that content of magnesium diboride is 50 mass% or more and 90 mass% or less. By using such a composition, it is possible to obtain the superconducting wire 10 having a higher critical current density. Incidentally, magnesium diboride used as the raw material is, for example, obtained by mixing magnesium and boron, and filing them in an inert atmosphere.

Further, in magnesium diboride to be filled in the metal sheath 2 constituting the precursor B, a part of boron atom sites of magnesium diboride contained may be substituted with carbon atom. By using such a material, it is possible to increase the critical current density in the high magnetic field region of the superconducting wire to be obtained. Such magnesium diboride whose part is substituted can be prepared by the method and material described in the above [1. Superconducting wire]. Further, the reason why the critical current density is increased is similar to the reason described in the above [1. Superconducting wire].

Primary structures of the precursor A and the precursor B are as described above, however, in either the precursor A or the precursor B, other optional components may be used in any amount as the raw material to be filled. Such components include, for example, a material (carbon source) containing carbon such as boron carbide.

Further, there is no particular limitation on the structure of the metal sheath 2 in the precursor A and the precursor B. Therefore, it is sufficient to apply the same structure as the metal sheath 2 described in [1. Superconducting wire]. That is, the metal sheath 2 preferably contains one or more metals selected from a group consisting of iron, niobium, tantalum, and titanium. Further, the outer surface of the metal sheath 2 is preferably coated with a material containing copper.

By firing the precursor A or the precursor B having the structure described above, the superconducting wire 10 is obtained. Note that, the superconducting wire 10 can also be obtained by filing a precursor having physical properties of both the precursor A and the precursor B. Before firing, the precursor A or the precursor B is linearized by an area reduction process so that the superconducting wire 10 to be obtained has a desired length and thickness. Then, the linearized precursor A or precursor B is subjected to firing.

Conditions during firing are not particularly limited. For example, it is sufficient to obtain the precursor A or the precursor B, and arrange the obtained precursor A or the precursor B in an electric furnace, and then carry out firing at a predetermined temperature and for a predetermined time. Such temperature and time can be, for example, 800 °C and 12 hours. Temperature may be changed stepwise, or may be always constant. Further, an atmosphere during filing is not particularly limited, either. The atmosphere can be, for example, an inert atmosphere such as argon, nitrogen, or the like.

By the method described above, the superconducting wire 10 can be obtained. In particular, the fabrication method of the precursor B is summarized as follows. That is, the precursor B is obtained by going through at least the following steps, a step of obtaining magnesium diboride by mixing and firing magnesium and boron, a step of preparing the obtained magnesium diboride so that a volume average particle diameter thereof is 10 $\mu$m or less, a step of obtaining a mixture by mixing magnesium, boron, and magnesium diboride with a volume average particle diameter of 10 $\mu$m or less, and a step of fabricating a wire by the area reduction process after filling the mixture into the metal sheath 2.

[3. Use of superconducting wire]

The superconducting wire 10, which is obtained by filing the precursor A or the precursor B, has a high critical current density, for example, even in high temperature range of 20 K or so. Therefore, by using such a superconducting wire 10, it is possible to drive more easily and inexpensively a superconducting magnet which is applied to a nuclear magnetic resonance analyzer, a medical magnetic resonance imaging diagnostic apparatus, or the like. That is, it is not necessary to cool to extremely low temperature by using expensive liquid helium for cooling the superconducting magnet, and it can be cooled by a refrigerator or the like. As a result, it is possible to reduce the running cost and manufacturing cost thereof.

Further, the above embodiment is described with an example of using a superconducting wire (single-core wire). However, a superconducting multi-core conductor can be, for example, formed by stopping once processing of the single-core wire at a thicker diameter thereof, and inserting such a plurality of single-core wires in the metal sheath by bundling them, and then performing the area reduction process. Further, for example, the superconducting multi-core conductor can also be formed by processing the single-core wire to a predetermined wire diameter, and twisting them together.

That is, the precursor A or the precursor B of the superconducting wire is obtained by the above-described fabrication method of the precursor A or the precursor B, and a precursor of the superconducting multi-core conductor can be obtained by twisting together the plurality of precursor A or precursor B of the superconducting wire. Then, by firing the precursor of the superconducting multi-core conductor which is obtained in this manner, the superconducting multi-core conductor can be obtained. Such superconducting multi-core conductor can have a current capacity higher than that of a superconducting single-core conductor (the superconducting wire 10 described above).

{Examples}

Hereinafter, the present embodiment will be described more specifically with examples.

<Example 1>

A superconducting wire was produced by using magnesium powder, boron powder, and magnesium diboride powder as raw material powders. And, properties of the produced superconducting wire were evaluated.

The magnesium powder (Mg) with a volume average particle diameter of 40 $\mu$m was used. This volume average particle diameter was measured by the method described above. The same applies to the following materials. The boron powder (B) and the magnesium diboride powder ($MgB_2$) are different for each superconducting wire which is produced, and those with volume average particle diameters listed in Table 1 below were used.

Note that, the magnesium diboride powder was obtained by mixing the magnesium powder with a volume average particle diameter of 40 $\mu$m and the boron powder with a volume average particle diameter of 2 $\mu$m, and filling them into a metal tube of material SUS304 and sealing both ends thereof, and then firing them in an argon atmosphere. Further, fine powders of the boron powder and the magnesium diboride powder were obtained by combining wet milling by a bead mill with dry milling by a planetary ball mill.

A composition was obtained by mixing the magnesium powder and the boron powder. The magnesium powder and the boron powder were mixed in a molar ratio of 1:2. Then, with this composition, the magnesium diboride powder obtained by the method described above was appropriately mixed so as to be each mixing ratio shown in Table 1. However, as for the superconducting wire of wire number 11, this composition was not used, but a composition of only magnesium diboride powder obtained by the method described above was used. Note that, "wt%" in Table 1 indicates "% by mass".

[Table 1]

| Wire number | Volume average particle diameter ($\mu$m) | | Mixing ratio of MgB$_2$ (wt%) |
| --- | --- | --- | --- |
| | B | MgB$_2$ | |
| 1 | 0.05 (Amorphous) | No addition | 0 |
| 2 | 45 (Crystalline) | No addition | 0 |
| 3 | 2 (Crystalline) | No addition | 0 |
| 4 | 0.5 (Crystalline) | No addition | 0 |
| 5 | 2 (Crystalline) | 50 | 50 |
| 6 | 2 (Crystalline) | 10 | 50 |
| 7 | 2 (Crystalline) | 2 | 50 |
| 8 | 2 (Crystalline) | 10 | 25 |
| 9 | 2 (Crystalline) | 10 | 75 |
| 10 | 2 (Crystalline) | 10 | 90 |
| 11 | 2 (Crystalline) | 10 | 100 |

The composition was filled in the metal sheath made of iron. An outer diameter of the metal sheath is 18 mm, and an inner diameter thereof is 13.5 mm. The metal sheath was thinned to a diameter $\varphi$ 0.5 mm by a drawing process, and a single-core wire was obtained. During the thinning, in wire #2 (wire number 2, the same for the other wires) and wire #5, the thinning was not easy, because breaking of wire occurred repeatedly during the drawing process. After all, a length of the wire has become shorter than that of other wires, although the wire was thinned to a diameter $\varphi$ 0.5 mm. As for the other wires, they were able to be thinned almost without breaking of wire.

By cutting off a length of 60 mm from the obtained single-core wire, and by firing it at 800 °C for 12 hours in an argon atmosphere, a powder filling portion of filament shape in the center was turned to magnesium diboride. That is, by firing, the superconducting wire 10 including the magnesium diboride core 1 shown in FIG. 1 was obtained.

With regard to the obtained superconducting wire 10, a relationship ($J_c$-B characteristics) between the critical current density ($J_c$ (A/mm$^2$)) and an external magnetic field (B (T)) at a temperature 20 K was evaluated by magnetization method. Specifically, the $J_c$-B characteristics was calculated by obtaining a magnetization curve by applying a magnetic field in a direction perpendicular to the longitudinal direction of the superconducting wire 10, and by applying an extended Bean model to an obtained magnetic hysteresis loop. Note that, the magnetization of the superconducting wire 10 was carried out by magnetic characteristic measuring apparatus MPMS of Quantum Design Japan, Inc.

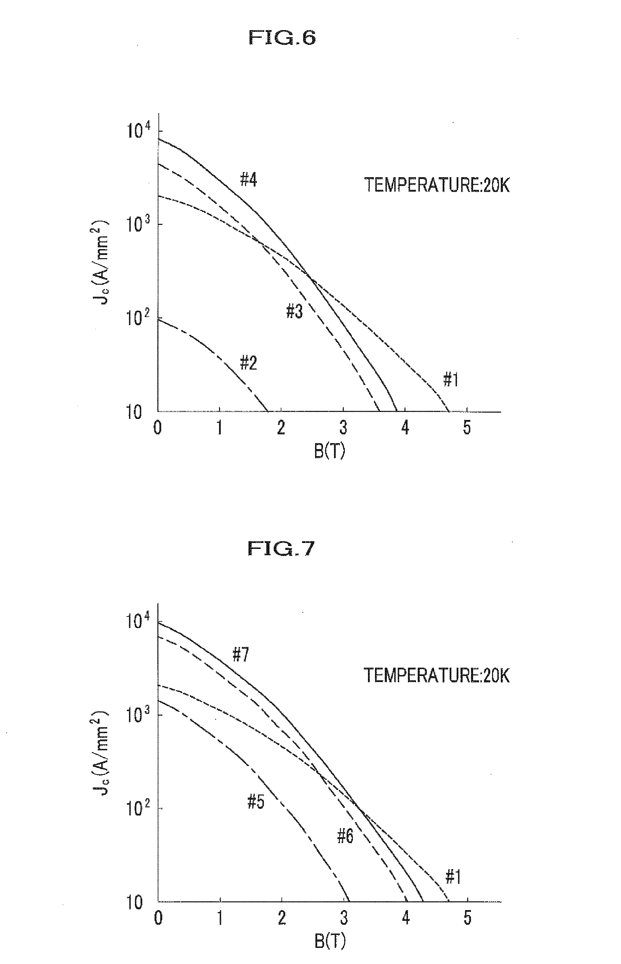

FIG. 6 shows the $J_c$-B characteristics of wires #1 to #4 at 20 K. Wire #1 is a wire of purity 99.99% amorphous boron powder with a volume average particle diameter of 0.05 $\mu$m, which is known to be able to obtain a high critical current density $J_c$. Wire #2 is a wire of crystalline boron powder with a volume average particle diameter of 45 $\mu$m, which is commercially readily available, and it can be seen that the critical current density $J_c$ is significantly lower than that of wire #1 over the entire magnetic field region.

Wires #3 and #4 use a raw material which is refined by grinding the crystalline boron powder used in wire #2. It can be seen that wires #3 and #4 has a critical current density higher than that of wire #1 particularly in a low magnetic field region (0T to about 2T). It is considered that this is because wires #3 and #4 use highly crystalline boron as the raw material.

That is, when using good crystalline boron, it is possible to obtain magnesium diboride having a small amount of voids as described below compared to when amorphous boron powder is used. When the amount of voids is small, since the superconducting current path is increased, the critical current density in the low magnetic field region is increased. On the other hand, when using good crystalline magnesium diboride, the critical current density in the high magnetic field region is reduced. It is considered that since magnesium diboride has good crystallinity in wires #3 and #4, ratios of reduction of the critical current density in the high magnetic field region in wires #3 and #4 are larger than that of wire #1. In other words, it can be said that by using good crystalline boron in wires #3 and #4, the critical current density in the low magnetic field region is good, although the critical current density in the high magnetic field region is reduced. Note that, the critical current density in the high magnetic field region can be improved by a method of <Example 2> to be described below.

From these results, it can be seen that the superconducting wire having a sufficiently high critical current density can be obtained by using the crystalline boron powder which is refined by grinding, without using a high-purity amorphous boron powder which is expensive and hard to obtain. Further, it can be seen that in the low magnetic field region, the critical current density higher than when using amorphous boron powder can be obtained.

FIG. 7 shows the $J_c$-B characteristics of wires #5 to #7 at 20 K. In addition, data of wire #1 as a comparative example is also shown. The critical current density of wire #5 is lower than that of wire #1 in the entire magnetic field region. It is considered that this is because the volume average particle diameter of magnesium diboride is too large. However, it can be seen that wires #6 and #7 has a critical current density higher than that of wire #1 particularly in a low magnetic field region (0T to about 3T). This reason is considered to be similar to the reason for wires #3 and #4 described above.

From these results, it is found that even without using the high-purity amorphous boron powder which is expensive and hard to obtain, by adding the magnesium diboride powder with a volume average particle diameter of 10 $\mu$m or less in addition to the magnesium powder and the boron powder, it is possible to obtain a superconducting wire having a sufficiently high critical current density.

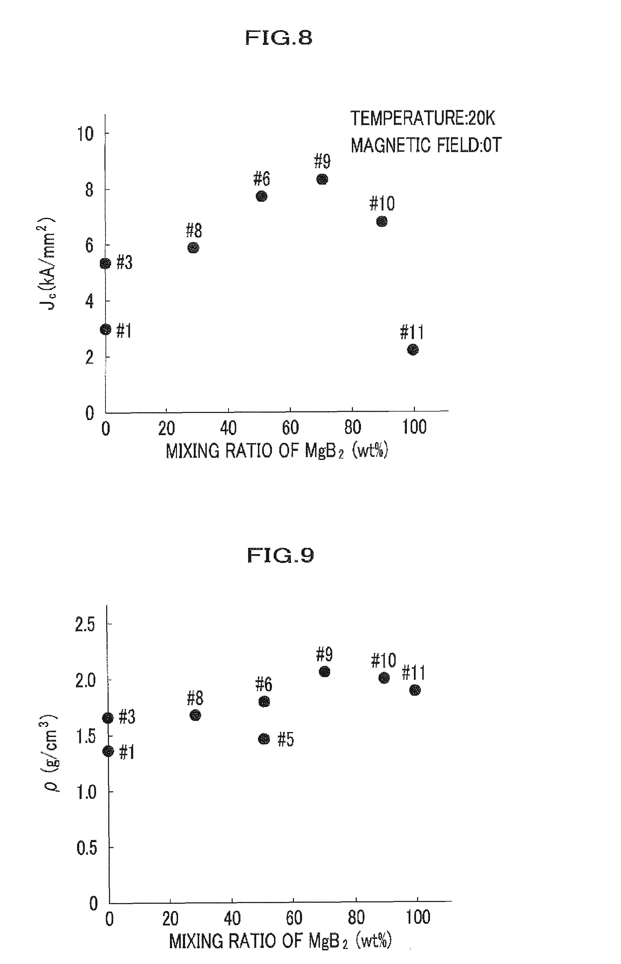

FIG. 8 shows relationships between the critical current density and the mixing ratio of magnesium diboride of wires #1, #3, #6, and # 8 to #11 at 20K, 0T. Wires #6 and # 8 to #11 which are mixed with magnesium diboride have increased critical current densities compared to that of wires #1 and #3 which are not mixed with magnesium diboride. From this result, it can be seen that the critical current density is increased by adding the magnesium diboride powder to a mixed powder of magnesium and boron.

In particular, when the mixing ratio of magnesium diboride is 50 wt% to 90 wt% as shown by wires #6, #9, and #10, it can be seen that the increasing effect is high. Further, as for the superconducting wires used in the evaluation in FIG. 8, the critical current densities of ten pieces of each superconducting wire were measured. As a result, while there is a variation of $\pm 40$ % in the critical current density of wire #11, a variation of each of the other wires is equal to $\pm 5$ % or less.

By the above results, it can be seen that it is possible to increase the critical current density of the super conducting wire which is obtained, by using the raw material of the crystalline boron powder having a volume average particle diameter of 2 $\mu$m or less, or by mixing the magnesium diboride powder having a volume average particle diameter of 10 $\mu$m or less with the raw material.

Next, for the purpose of obtaining universal characteristics for obtaining a superconducting wire of high performance magnesium diboride, the wires described above were analyzed in detail.

In wires #1, #3, #5, #6, and #8 to #11, by removing an iron sheath very carefully, a columnar magnesium diboride core inside was taken out. The size and mass of the magnesium diboride core taken out were measured. A core density $\rho$ of magnesium diboride is defined as a value obtained by dividing the mass of the magnesium diboride core by a volume thereof.

FIG. 9 shows relationships between the core density $\rho$ and the mixing ratio of magnesium diboride. It can be seen that the core density $\rho$ of wire #1 using the amorphous boron powder is lower than that of the other wires using the crystalline boron powder. It is considered that this is because a density of amorphous boron is 1.7 g/cm$^3$, and is lower than a density 2.37 g/cm$^3$ of crystalline boron.

Further, in wires #6 and #8 to #11 which are mixed with the magnesium diboride powder, it is observed that the core density $\rho$ is further increased. The density of magnesium diboride is as large as 2.62 g/cm$^3$, whereas the density of magnesium is 1.74 g/cm$^3$ and the density of crystalline boron is 2.37 g/cm$^3$. Therefore, volume shrinkage occurs during firing, and the voids are formed in the magnesium diboride core. However, in these wires, it is considered that since magnesium diboride was mixed with the raw material in advance, an amount of the volume shrinkage was effectively reduced.

However, as for wire #5 in which the particle diameter of the magnesium diboride powder is large, the core density $\rho$ thereof is lower than that of wire #3 which is not mixed with the magnesium diboride powder. It is considered that this is because the coarse magnesium diboride powder reduces the packing density.

As described above, by using as the raw material the crystalline boron powder having a volume average particle diameter of 2 $\mu$m or less, or by mixing the magnesium diboride powder having a volume average particle diameter of 10 $\mu$m or less with the raw material, the critical current density of the superconducting wire is improved. The reason is considered as follows. That is, it is considered that the current path is increased because the core density $\rho$ is increased, and as a result, the critical current density is improved.

When using the amorphous boron powder as the raw material, and not using the magnesium diboride powder, the packing ratio of the precursor of the superconducting wire into the metal sheath is about 90 % even at the maximum. The density of magnesium is 1.74 g/cm$^3$, and the density of amorphous boron is 1.7 g/cm$^3$. That is, when filling magnesium and amorphous boron into the metal sheath, in view of the fact that the voids of about 34 % are formed due to the packing ratio (about 90 %) and the volume shrinkage associated with firing, the density of the magnesium diboride core obtained after firing is about 1.5 g/cm$^3$ even at the maximum. The density of crystalline boron is greater than that of amorphous boron. Therefore, the density of the magnesium diboride core of the superconducting wire which is obtained from the raw material of crystalline boron is 1.5 g/cm$^3$ or more. In other words, by using the crystalline boron powder, it is possible to increase the density of the magnesium diboride core as compared with a case of using the amorphous boron powder.

Further, wire #11 has a relatively high core density $\rho$, however, the critical current density thereof is low and the variation thereof is large. In order to clarify the reason, longitudinal cross-sections of wires #4 and #11 were observed by a scanning electron microscope (SEM). The results are schematically shown in FIGS. 2A and 3. In other words, FIG. 2A schematically shows the longitudinal cross-section of wire #4, and FIG. 3 schematically shows the longitudinal cross-section of wire #11 (a comparative example).

Note that, in order to observe the longitudinal cross-section by the SEM, after embedding the wire in resin, the longitudinal cross-section was obtained by cutting the wire in the current flow direction thereof by dry grinding, and the obtained longitudinal cross-section was further smoothed by ion milling, to observe a state thereof.

As shown in FIGS. 2 and 3, the voids 4 are present in both wires. However, the shape and direction of the voids 4 are random in wire #11, whereas a large majority of the voids 4 are extended in the longitudinal direction of the wire in wire #4. Further, with regard to the size of the voids 4, in the voids 4 with a size of 20 $\mu$m or more of wire #4, the angles $\theta$ of the voids 4 of 80 % or more are smaller than 20°. On the other hand, in wire #11, the number of voids having angles $\theta$ of 45° or more is approximately equal to or slightly greater than the number of voids having angles $\theta$ smaller than 45°.

The voids 4, which have angles $\theta$ larger than 45° and sizes not negligible compared to the diameter of the magnesium diboride core 1, narrow the current path locally. It is considered that such voids 4 cause a variation of the critical current density in addition to a decrease of the critical current density. Therefore, a reason why the critical current density of wire #11 is low is due to the fact that there are many voids 4 having angles of 45° or more.

Further, the boundary surface 5 between the magnesium diboride core 1 and the metal sheath 2 is linear, with exceptions of wires #2 and #5 in which breaking of the wires occurred. That is, in FIG. 4 described above, all of x1, x2, and x3 are 10 $\mu$m or less. In other words, the distance between the boundary curve 5 and the approximate straight line 6 is 10 $\mu$m or less. On the other hand, with regard to wires #2 and #5 in which breaking of the wires occurred, the boundary surface 5 between the magnesium diboride core 1 and the metal sheath 2 has an extremely large undulation. In other words, the distance between the boundary curve 5 and the approximate straight line 6 is beyond 10 $\mu$m.

Breaking of wires #2 and #5 is considered to be due to such a large undulation. That is, it is considered that a portion of locally thin thickness (weak strength) is formed in the metal sheath 2, and the portion became a starting point to cause breaking of the wire. Therefore, in order to obtain the superconducting wire of a long wire length, it is important that the boundary surface 5 between the magnesium diboride core 1 and the metal sheath 2 is linear. Here, "linear" means that the distance between the boundary curve 5 and the approximate straight line 6 is 10 $\mu$m or less.

Further, in wires #2 and #5 in which breaking of the wires occurred, the sizes of magnesium diboride 7 and boron 8 shown in FIG. 5 described above are coarsened very much. When the sizes of magnesium diboride 7 and boron 8 are too large in this way, a phenomenon of excessively biting into an inner wall of the metal sheath 2 occurs during area reduction process. As a result, the portion of locally thin thickness is formed as described above, and the breaking of the wire occurs. From these results, in order to obtain the superconducting wire of a long wire length, it is important to reduce volume average particle diameters of the boron powder and the magnesium diboride powder.

Note that, magnesium 9 shown in FIG. 5 was observed in a form of being extended in the longitudinal direction of the wire. From this fact, it is understood that magnesium 9 is easily plastically deformed during area reduction process compared to magnesium diboride 7 and boron 8. Therefore, magnesium 9 is considered not to be a cause of preventing elongation, even if it is coarsened.

<Example 2>

As the raw materials, the magnesium powder, the boron powder, the magnesium diboride powder, and the boron carbide (B$_4$C) powder were prepared. The volume average particle diameters of the magnesium powder, the boron powder, the magnesium diboride powder, and the boron carbide powder are respectively 40 $\mu$m, 2 $\mu$m, 10 $\mu$m, and 0.05 $\mu$m. Note that, the magnesium diboride powder was prepared by the same method as Example 1 described above, after mixing the magnesium powder with a volume average particle diameter of 40 $\mu$m, the boron powder with a volume average particle diameter of 2 $\mu$m, and the boron carbide powder with a volume average particle diameter of 0.05 $\mu$m in a molar ratio of 1:1.9:0.02.

Then, the magnesium powder, the boron powder, the boron carbide powder, and the obtained magnesium diboride powder were mixed together. In the mixed powders, the composition of these is 1:1.9:0.02:1 as a molar ratio. By using the mixed powders, superconducting wire #6C was obtained by the same method as Example 1 described above. Note that, the superconducting wire #6C is a wire that boron carbide is added to the above-described wire #6. With regard to the obtained superconducting wire #6C, the $J_c$-B characteristics were evaluated by the same method as Example 1.

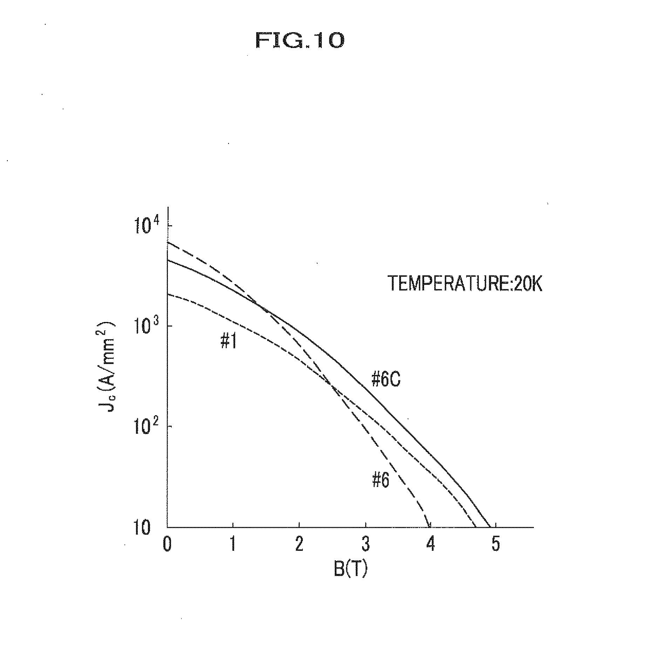

The result is shown in FIG. 10. Note that, the results of wires #1 and #6 are also shown in FIG. 10. As shown in wire #6C in FIG. 10, the critical current density specifically in the high magnetic field region (about 1.5 T to 5 T or so) is increased by addition of boron carbide. In addition, wire #6C shows higher critical current density than that of wire #1 using the amorphous boron powder of high purity in the entire magnetic field region measured.

It is considered that this result is because a part of boron atom sites of magnesium diboride is substituted with carbon atom and thus a lattice distortion occurs. Then, it is considered that this result is because such a lattice distortion occurs and thus a coherence length is reduced and a pinning force in a grain boundary is increased. As described above, by adding to the raw material powder a material containing carbon in boron carbide or the like, it was found that the critical current density in the high magnetic field region can be improved. That is, it was found that the superconducting wire having a high critical current density in the magnetic field region of a wider range can be obtained.

{Reference Signs List}

1: magnesium diboride core
2: metal sheath
4: void
5: boundary surface (boundary curve)
6: approximate straight line
7: magnesium diboride
8: boron
9: magnesium
10: superconducting wire

**Claims**

1. A superconducting wire having a magnesium diboride core made of magnesium diboride which is electrically continuous, and a metal sheath which covers the magnesium diboride core,
   wherein a density of the magnesium diboride core is 1.5g/cm$^3$ or higher,
   wherein in a void which is present in an arbitrary longitudinal cross-section in the longitudinal direction of the superconducting wire, when a length of a line segment which connects the most distant two points in a closed curve forming the void is assumed to be L, among the voids with length L of 20 $\mu$m or greater, the number of voids having an angle of 45° or greater, which is formed by the line segment and the axis in the longitudinal direction of the superconducting wire, is less than the number of voids having an angle smaller than 45°, which is formed by the line segment and the axis in the longitudinal direction of the superconducting wire, and
   wherein in an arbitrary 100$\mu$m region in the longitudinal direction of the longitudinal cross-section, when a virtual straight line approximated by the least squares method is drawn for a boundary curve between the magnesium diboride core and the metal sheath, a distance between the approximate straight line and the boundary curve is 10 $\mu$m or less.

2. The superconducting wire according to claim 1, wherein a part of boron atom sites of magnesium diboride is substituted with carbon atom.

3. The superconducting wire according to claim 1 or 2, wherein the metal sheath contains one or more metals selected from a group consisting of iron, niobium, tantalum, and titanium.

4. The superconducting wire according to claim 1 or 2, wherein an outer surface of the metal sheath is covered with a material containing copper.

5. A precursor of a superconducting wire, which is a precursor of a magnesium diboride superconducting wire having a magnesium diboride core made of magnesium diboride which is electrically continuous, and a metal sheath which covers the magnesium diboride core,
   wherein the magnesium diboride core is formed by firing after filling magnesium and boron into the metal sheath,

wherein the boron is crystalline, and
wherein a volume average particle diameter of the boron is 2 $\mu$m or less.

6. A precursor of a superconducting wire, which is a precursor of a magnesium diboride superconducting wire having a magnesium diboride core made of magnesium diboride which is electrically continuous, and a metal sheath which covers the magnesium diboride core,
wherein the magnesium diboride core is formed by firing after filling magnesium, boron, and magnesium diboride into the metal sheath, and
wherein a volume average particle diameter of magnesium diboride to be filled in the metal sheath is 10 $\mu$m or less.

7. The precursor of the superconducting wire according to claim 6, wherein in a raw material to be filled in the metal sheath, a content of magnesium diboride is 50 mass% or more, and 90 mass% or less.

8. The precursor of the superconducting wire according to claim 6 or 7, wherein a part of boron atom sites of magnesium diboride to be filled in the metal sheath is substituted with carbon atom.

9. The precursor of the superconducting wire according to claim 6 or 7, wherein a material containing carbon is filled in the metal sheath.

10. The precursor of the superconducting wire according to claim 6 or 7, wherein the metal sheath contains one or more metals selected from a group consisting of iron, niobium, tantalum, and titanium.

11. The precursor of the superconducting wire according to claim 6 or 7, wherein an outer surface of the metal sheath is covered with a material containing copper.

12. A fabrication method of a precursor of a superconducting wire, which is a method of fabricating a precursor of a magnesium diboride superconducting wire having a magnesium diboride core made of magnesium diboride which is electrically continuous, and a metal sheath which covers the magnesium diboride core, comprising the following steps:

a step of obtaining magnesium diboride by mixing and firing magnesium and boron;
a step of preparing the obtained magnesium diboride so that a volume average particle diameter thereof is 10 $\mu$m or less;
a step of obtaining a mixture by mixing magnesium, boron, and magnesium diboride having a volume average particle diameter of 10 $\mu$m or less; and
a step of fabricating a wire by an area reduction process after filling the mixture into the metal sheath.

13. A precursor of a superconducting multi-core conductor, which is formed by obtaining the precursor of the superconducting wire by the fabrication method of the precursor of the superconducting wire according to claim 12, and by twisting together a plurality of precursors of the superconducting wire obtained.

**Amended claims under Art. 19.1 PCT**

1. A superconducting wire having a magnesium diboride core made of magnesium diboride which is electrically continuous, and a metal sheath which covers the magnesium diboride core,
wherein a density of the magnesium diboride core is 1.5g/cm$^3$ or higher,
wherein in a void which is present in an arbitrary longitudinal cross-section in the longitudinal direction of the superconducting wire, when a length of a line segment which connects the most distant two points in a closed curve forming the void is assumed to be L, among the voids with length L of 20 $\mu$m or greater, the number of voids having an angle of 45° or greater, which is formed by the line segment and the axis in the longitudinal direction of the superconducting wire, is less than the number of voids having an angle smaller than 45°, which is formed by the line segment and the axis in the longitudinal direction of the superconducting wire, and
wherein in an arbitrary 100$\mu$m region in the longitudinal direction of the longitudinal cross-section, when a virtual straight line approximated by the least squares method is drawn for a boundary curve between the magnesium diboride core and the metal sheath, a distance between the approximate straight line and the boundary curve is 10 $\mu$m or less.

2. The superconducting wire according to claim 1, wherein a part of boron atom sites of magnesium diboride is substituted with carbon atom.

3. The superconducting wire according to claim 1 or 2, wherein the metal sheath contains one or more metals selected from a group consisting of iron, niobium, tantalum, and titanium.

4. The superconducting wire according to claim 1 or 2, wherein an outer surface of the metal sheath is covered with a material containing copper.

5. A precursor of a superconducting wire, which is a precursor of a magnesium diboride superconducting wire having a magnesium diboride core made of magnesium diboride which is electrically continuous, and a metal sheath which covers the magnesium diboride core,
wherein the magnesium diboride core is formed by firing after filling magnesium and boron into the metal sheath,
wherein the boron is crystalline, and
wherein a volume average particle diameter of the boron is 2 $\mu$m or less.

6. (Amended) The precursor of the superconducting wire according to claim 5, wherein the volume average particle diameter of the boron is 0.5 $\mu$m or less.

7. (Amended) The precursor of the superconducting wire according to claim 5,
wherein the magnesium diboride core is formed by filing after filling magnesium, boron, and magnesium diboride into the metal sheath, and
wherein a volume average particle diameter of magnesium diboride to be filled in the metal sheath is 10 $\mu$m or less.

8. (Amended) The precursor of the superconducting wire according to claim 7, wherein in a raw material to be filled in the metal sheath, a content of magnesium diboride is 50 mass% or more, and 90 mass% or less.

9. (Amended) The precursor of the superconducting wire according to claim 7 or 8, wherein a part of boron atom sites of magnesium diboride to be filled in the metal sheath is substituted with carbon atom.

10. (Amended) The precursor of the superconducting wire according to claim 7 or 8, wherein a material containing carbon is filled in the metal sheath.

11. (Amended) The precursor of the superconducting wire according to claim 7 or 8, wherein the metal sheath contains one or more metals selected from a group consisting of iron, niobium, tantalum, and titanium.

12. (Amended) The precursor of the superconducting wire according to claim 7 or 8, wherein an outer surface of the metal sheath is covered with a material containing copper.

13. (Amended) A fabrication method of a precursor of a superconducting wire, which is a method of fabricating a precursor of a magnesium diboride superconducting wire having a magnesium diboride core made of magnesium diboride which is electrically continuous, and a metal sheath which covers the magnesium diboride core, comprising the following steps:

a step of obtaining magnesium diboride by mixing and firing magnesium and crystalline boron having a volume average particle diameter of 2 $\mu$m or less;
a step of preparing the obtained magnesium diboride so that a volume average particle diameter thereof is 10 $\mu$m or less;
a step of obtaining a mixture by mixing magnesium, crystalline boron having a volume average particle diameter of 2 $\mu$m or less, and magnesium diboride having a volume average particle diameter of 10 $\mu$m or less; and
a step of fabricating a wire by an area reduction process after filling the mixture into the metal sheath.

14. (Added) A precursor of a superconducting multi-core conductor, which is formed by obtaining the precursor of the superconducting wire by the fabrication method of the precursor of the superconducting wire according to claim 13, and by twisting together a plurality of precursors of the superconducting wire obtained.

**Statement under Art. 19.1 PCT**

1. Claim 6 is amended based on a volume average particle diameter "0.5 $\mu$m" of boron of "wire number 4" described in Table 1 in paragraph 0058 of the original description and the description in paragraph 0070 of the original description.

2. Claim 7 corresponds to original Claim 6. An amendment from "that is a precursor of a magnesium diboride superconducting wire having a magnesium diboride core made of magnesium diboride which is electrically continuous, and a metal sheath which covers the magnesium diboride core" to "The precursor of the superconducting wire according to claim 5" is based on descriptions in paragraphs 0058 and 0070 of the original description. That is, in paragraphs 0058 and 0070, it is described that crystalline boron (crystalline boron powder) having a volume average particle diameter of 2 $\mu$m or less and magnesium diboride having a volume average particle diameter of 10 $\mu$m or less are used as the raw material for wire numbers 6 to 10, and the like.

3. Claims 8 to 12 respectively correspond to original Claims 7 to 11. In all of Claims 8 to 12, each claim number of dependent destination is moved down by one, in association with the amendment of Claim 6.

4. Claim 13 corresponds to original Claim 12. Amendments from "boron" to "crystalline boron having a volume average particle diameter of 2 $\mu$m or less" are based on descriptions in paragraphs 0058 and 0070 of the original description. That is, in paragraphs 0058 and 0070, it is described that crystalline boron (crystalline boron powder) having a volume average particle diameter of 2 $\mu$m or less is used as the raw material for wire numbers 6 to 10, and the like.

5. Claim 14 corresponds to original Claim 13. In Claim 14, a claim number of dependent destination is moved down by one, in association with the amendment of Claim 6.

6. As described above, the amendments do not add new matter.

7. None of documents 1 to 6 cited by the Examiner in the Written Opinion of the International Searching Authority discloses or suggests the precursor of the superconducting wire obtained by using crystalline boron having a volume average particle diameter of 2 $\mu$m or less. Further, it is not a technical common knowledge of those skilled in the art to use crystalline boron in particular as the precursor of the superconducting wire. Therefore, the precursor of the superconducting wire of Claims 5 to 12 and the fabrication method of the precursor of the superconducting wire of Claims 13 and 14 are not readily apparent to even those skilled in the art based on the cited documents 1 to 6.

# FIG.1

10

A    A

1    2

FIG.2A

FIG.2B

L

4

LINE SEGMENT

θ

AXIS IN LONGITUDINAL
DIRECTION OF WIRE

FIG.3

# FIG.4

# FIG.5

## FIG.6

## FIG.7

## FIG.8

## FIG.9

FIG.10

## INTERNATIONAL SEARCH REPORT

| International application No. |
| --- |
| PCT/JP2013/062185 |

### A. CLASSIFICATION OF SUBJECT MATTER
*H01B12/04*(2006.01)i, *C01B35/04*(2006.01)i, *C01G1/00*(2006.01)i, *H01B12/08* (2006.01)i, *H01B13/00*(2006.01)i, *H01F6/06*(2006.01)i

According to International Patent Classification (IPC) or to both national classification and IPC

### B. FIELDS SEARCHED

Minimum documentation searched (classification system followed by classification symbols)
H01B12/04, C01B35/04, C01G1/00, H01B12/08, H01B13/00, H01F6/06

Documentation searched other than minimum documentation to the extent that such documents are included in the fields searched
Jitsuyo Shinan Koho       1922-1996   Jitsuyo Shinan Toroku Koho   1996-2013
Kokai Jitsuyo Shinan Koho  1971-2013   Toroku Jitsuyo Shinan Koho   1994-2013

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X<br>A | JP 2007-059261 A  (Independent Administrative Institution National Institute for Materials Science),<br>08 March 2007 (08.03.2007),<br>claims; paragraph [0011]<br>& US 2007/0054810 A1 | 5<br>1-4 |
| Y<br>A | JP 2005-310600 A  (Tokyo Wire Works Ltd.),<br>04 November 2005 (04.11.2005),<br>claims; paragraph [0030]<br>(Family: none) | 6-13<br>1-4 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>18 July, 2013 (18.07.13) | Date of mailing of the international search report<br>30 July, 2013 (30.07.13) |
| --- | --- |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
|---|
| PCT/JP2013/062185 |

C (Continuation).    DOCUMENTS CONSIDERED TO BE RELEVANT

| Category* | Citation of document, with indication, where appropriate, of the relevant passages | Relevant to claim No. |
|---|---|---|
| Y<br>A | JP 2006-269277 A  (Kobe Steel, Ltd.),<br>05 October 2006 (05.10.2006),<br>claims; paragraphs [0020], [0025]<br>& US 2006/0216191 A1    & EP 1705721 A2<br>& DE 602006019166 A     & KR 2006/0103160 A<br>& CN 1837391 A          & AT 493765 A | 6-13<br>1-4 |
| A | JP 2009-134969 A  (Hitachi, Ltd.),<br>18 June 2009 (18.06.2009),<br>paragraph [0051]<br>(Family: none) | 1-4 |
| A | JP 2006-236939 A  (Sumitomo Electric Industries,<br>Ltd.),<br>07 September 2006 (07.09.2006),<br>paragraph [0038]<br>(Family: none) | 1-4 |
| A | JP 2006-127898 A  (Sumitomo Electric Industries,<br>Ltd.),<br>18 May 2006 (18.05.2006),<br>paragraph [0010]<br>& US 2008/0274900 A1    & EP 1806328 A1<br>& WO 2006/046535 A1    & KR 2007/0040804 A<br>& CN 101001820 A        & RU 2006145640 A | 1-4 |

Form PCT/ISA/210 (continuation of second sheet) (July 2009)

**REFERENCES CITED IN THE DESCRIPTION**

**Patent documents cited in the description**

- JP 4667638 B

- JP 2003031057 A